# EUROPEAN PATENT APPLICATION

(11) **EP 2 657 696 A1**
(43) Date of publication of application: **30.10.2013**
(21) Application number: 10861194.8
(22) Date of filing: 20.12.2010
(51) Int. Cl.: G01N 30/02

(54) **ULTRAVIOLET PRETREATMENT DEVICE**

(71) Applicant: Beijing Titan Instruments Co. Ltd., Beijing 100015 (CN)
(72) Inventor: LIU, Jixin, Beijing 100016 (CN); QIN, Deyuan, Beijing 100016 (CN); ZHAO, Liqian, Beijing 100016 (CN); ZHOU, Qi, Beijing 100016 (CN); YE, Jianping, Beijing 100016 (CN); ZHENG, Fengxi, Beijing 100016 (CN)
(74) Representative: Gulde Hengelhaupt Ziebig & Schneider
(86) International application number: PCT/CN2010/079992
(87) International publication number: WO 2012/083513

(57) **Abstract**

The Ultraviolet pretreatment device in the present invention relates to an interface technique in the field of coupling technology for the analysis of chemical element species. The objective is to provide an Ultraviolet pretreatment device with simple structure, enhanced UV illuminance, and high digestion efficiency. The Ultraviolet pretreatment device in the present invention comprises low pressure Mercury lamp and quartz tube, wherein, the said low pressure Mercury lamp comprises lamp tube, electrodes and power source. The said quartz tube is located within the said lamp tube, the two ends of the quartz tube are fixedly and respectively joined with the tube wall of the lamp tube, the inner wall of the said lamp tube and the outer wall of the quartz tube form a sealed gas chamber, and the said electrodes are located in the gas chamber.

## Description

### Field of the Invention

The present invention relates to an interface technique in the field of coupling technology for the analysis of chemical element species, and in particular relates to a device for digestion or photochemical reaction using Ultraviolet (UV) rays.

### Background of the Invention

Ultraviolet pretreatment device is widely used at present in the analysis of chemical element species, and is almost an indispensable accessory. A number of chemical elements have various types of species, such as inorganic and organic species, low oxidation state and high oxidation state species; Arsenic (As) has the species of Arsenite [As(III)] and Arsenate [As (V)] in its inorganic form, and Di-methyl Arsenate (DMA), Mono-methyl Arsenate (MMA) in its organic form; and so on. Different species of chemical elements exhibit different toxicity: As (III) and As (V) both are deadly toxic, while DMA and MMA are basically harmless to the human body. In order to accurately assess the toxicity of elements contained in the sample, it is necessary to conduct species analysis of the elements. The coupling of liquid chromatography and spectroscopic detector is a widely used device at present in the analysis of element species. First, conduct the separation in the chromatograph; then the isolates flowing out of the column undergo hydride formation reaction, and generate gaseous hydride; and then introduce it into the spectroscopic detector for detecting. In the derivative process of hydride formation, different element species have different hydride formation efficiency. Among the Arsenic species, As (III) has the highest formation efficiency, while the Arsenic Betaine (AsB) in animal products, Roxarsone and Arsanilic Acid (p-ASA) in animal feed have very low direct hydride formation efficiency, and is very difficult to be detected. In other elements, such as Mercury, Selenium, Tin, and Antimony, etc., their organic forms present similar situation. The common solution for this is to digest the organic forms of elements into inorganic forms by Ultraviolet pretreatment before the derivative process, so as to boost the hydride formation efficiency, and thereby enhance the detection signal. Also, there is essentially no hydride signal for Selenate [Se (VI)]. So it also needs to go through the Ultraviolet pretreatment, in order to be reduced to Selenite [Se (IV)] by the energy obtained from the Ultraviolet pretreatment, and enhance the detection signal.

Another important application of the Ultraviolet pretreatment device is as a photochemical reactor. Studies have found that, after the UV irradiation using the medium which contains some low molecular weight organic solvents (such as Formic Acid, Acetic Acid, Propionic Acid, Formaldehyde, etc.) in its solution, many elements can form their corresponding gaseous substances. Such elements include the traditional hydride formation elements of Arsenic, Antimony, Selenium, Tin, and Mercury, etc., the transition elements of Nickel, Cobalt, Copper, and Iron, the noble metal elements of Silver, Gold, and Platinum, and the nonmetallic elements of Iodine and Sulfur. The underlying principle behind this is that, by UV irradiation, small molecular weight organic solvents can generate free radical molecules in its excited state, and the excited free radical molecules react with the target element in the solution, thus generating respective gaseous substances. Especially with Mercury, without the assistance of low molecular weight organic reagents, it can directly generate elemental Mercury by UV irradiation. In the photochemical reaction of Mercury, the role of the low molecular weight organic reagents is only to eliminate the interference.

The traditional Ultraviolet pretreatment device, such as the "On-line UV digestion/reduction system for the coupling system of liquid chromatography and atomic fluorescence spectroscopy" disclosed in the Chinese utility model patent of CN201184876Y, is simply winding the quartz tube on the UV lamp surface, and then let the sample solution flow through the UV lamp surface. There are several disadvantages with this type of working mode. First, the light intensity is not strong enough. This is because the light emitted from the Ultraviolet lamp must go through the lamp wall, and further go through the winding quartz tube before it irradiates the sample solution, thus significantly weakening the irradiation intensity on the solution. Another disadvantage is the considerable matrix interference in the sample solution. When the sample solution contains high concentrations of organic solvents, such as Methanol and Acetonitrile, these organic solvents will absorb a large amount of incident UV light, resulting in a very low effective light intensity irradiated on the sample solution and seriously affecting the digestion efficiency. The experiment results show that, for the AsB sample solution containing 0.5% Methanol, there is no signal detected at all. This problem poses restriction that the mobile phase cannot use high concentrations of organic solvents, and renders it impossible to perform some element species analyses which require the use of high concentration organic solvent as mobile phase. For example, the separation of Tin species requires at least 90% of Methanol as the mobile phase, and the sample solution needs to be premixed with oxidizing agent (Potassium Persulfate or Hydrogen Peroxide) to enhance the digestion efficiency.

### Description of the Invention

The objective of the present invention is to solve the technical problem to provide a Ultraviolet pretreatment device with simple structure, enhanced UV illuminance, and high digestion efficiency.

The Ultraviolet pretreatment device in the present invention comprises a low pressure Mercury lamp and a quartz tube, wherein: the said low pressure Mercury lamp comprises a lamp tube, electrodes and a power source; the said quartz tube is located inside the said lamp tube, and the two ends of the quartz tube are fixedly and respectively joined with the wall of the lamp tube; the inner wall of the said lamp tube and the outer wall of the quartz tube form a sealed gas chamber, and the said electrodes are located in the gas chamber.

In the Ultraviolet pretreatment device of the present invention, the two ends of the said quartz tube are connected to the inlet end and the outlet end respectively, and the said inlet end and the outlet end are located outside the said lamp tube.

In the Ultraviolet pretreatment device of the present invention, the said quartz tube consists of a plurality of straight-line sections and bending sections, the said straight-line sections are, in parallel to each other, distributed within the lamp tube along the tube length direction, and the straight-line sections are mutually communicated through the bending sections.

In the Ultraviolet pretreatment device of the present invention, the said bending section is substantially U-shaped, and the outer wall of the bending section is fixedly joined with the wall of the said lamp tube.

In the Ultraviolet pretreatment device of the present invention, the said lamp tube is made from quartz, and the said quartz tube and the lamp tube are mutually fixed by sintering.

The difference between the existing technology and the Ultraviolet pretreatment device in the present invention is that, in the Ultraviolet pretreatment device of the present invention: the pipeline through which the sample solution flows is placed inside the low pressure Mercury lamp; the said pipeline is made from quartz, which has excellent light transmittance; when the Mercury lamp is at work, the emitted Ultraviolet light can fully act on the solution in the quartz tube, thus greatly enhancing the light intensity being irradiated. There are two points with respect to the mechanism of this action. First, the quartz tube inside the lamp is subjected to irradiation from multiple directions, so the irradiation intensity is greatly improved; second, with the placement of quartz tube inside the lamp, the Mercury glow discharge will take place along its surface, thus further enhancing the illuminance. The Ultraviolet pretreatment device in the present invention completely overcomes some shortcomings of the traditional Ultraviolet pretreatment device. First, the light irradiation intensity is greatly improved. Meanwhile, the interference problem of high concentration organic matrix in the sample solution is substantially solved. Experiments show that, even if the solution contains 30% of Methanol, the AsB can still produce good signal. Thus, the technique presented in the present invention overcomes the restrictions caused by the high concentration organic solvent in the mobile phase, which makes the species analysis of Tin, Lead and other elements possible. Further, no oxidizing agent is needed as auxiliary solvent, thus saving the solvent consumption.

Next, with reference to the drawings, the Ultraviolet pretreatment device in the present invention will be further described.

### Description of the Drawings

Figure 1 is the structure diagram of the Ultraviolet pretreatment device in the present invention;
Figure 2 shows the digestion efficiency of AsB in varying Methanol concentrations;
Figure 3 is the spectrum of Mercury species after photochemical reaction and conversion.

### Mode of the Embodiment

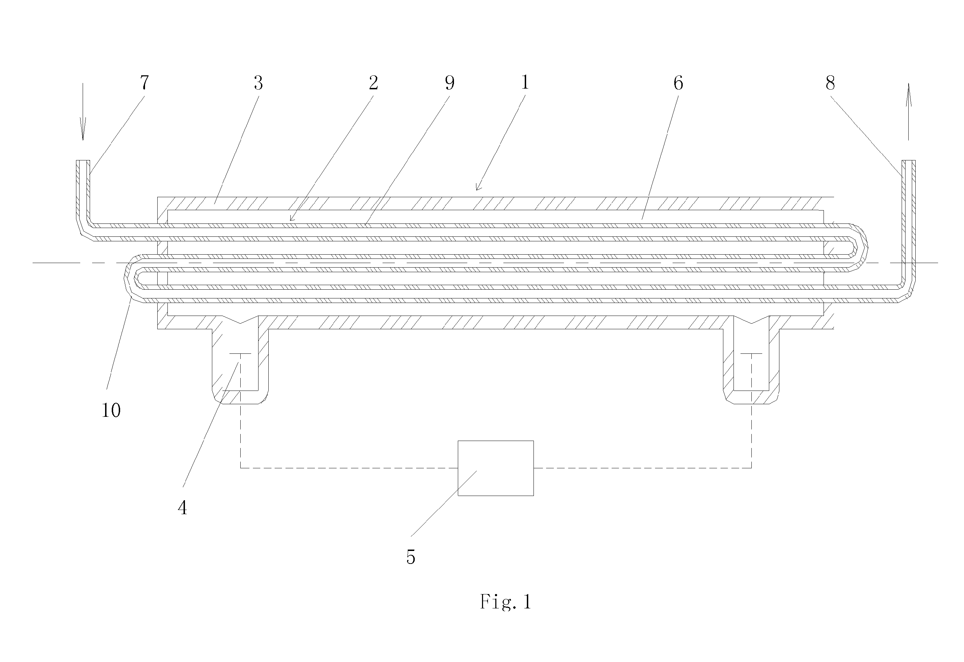

As shown in Figure 1, the Ultraviolet pretreatment device in the present invention comprises a low pressure Mercury lamp 1 and a quartz tube 2. The low pressure Mercury lamp 1 comprises a quartz lamp tube 3, electrodes 4 and a power source 5. The quartz tube 2 is located inside the lamp tube 3, and the two ends of the quartz tube 2 are fixedly and respectively joined with the tube wall of the lamp tube 3 by way of sintering. The quartz tube 2 consists of a plurality of straight-line sections 9 and the bending sections 10. The straight-line sections 9 are, in parallel to each other, distributed within the lamp tube 3 along the tube length direction, and the straight-line sections 9 are mutually communicated through the U-shape bending sections 10. The outer wall of the bending sections 10 is fixedly joined with the tube wall of the lamp tube 3 by sintering. The inner wall of the lamp tube 3 and the outer wall of the quartz tube 2 form a sealed gas chamber 6, the gas chamber 6 is filled with low pressure Mercury vapor, and the electrodes 4 are located in the gas chamber 6. The two ends of the quartz tube 2 are connected to the inlet end 7 and the outlet end 8 respectively, and the inlet end 7 and the outlet end 8 are located outside the lamp tube 3. The solution to be measured can enter the quartz tube 2 from the inlet end 7, and flow out from the outlet end 8.

### Embodiment 1 of the Invention

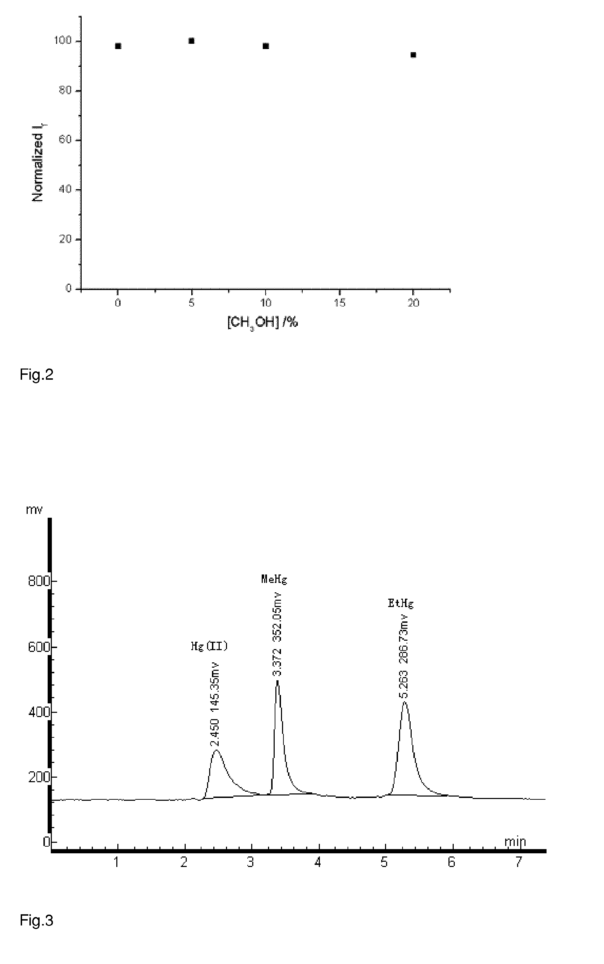

Prepare 50 µg/L AsB solution in pH 6.0 phosphate buffer solution. Without the addition and assistance of any oxidants, directly irradiate the solution using the Ultraviolet pretreatment device in the present invention at varying peristaltic pump speeds. Detect with the irradiated solution using species analyzer, and obtain the digestion conversion rates of AsB, as seen in Table 1. Also, check on the change of the digestion efficiency of AsB at varying Methanol concentrations, as shown in Figure 2. The results show that, thanks to the enhanced digestion ability of the Ultraviolet pretreatment device in the present invention, the AsB signals are basically not affected by the Methanol concentration.

**Table 1 The results of digestion conversion rates of AsB**

| Peristaltic pump speed (rpm) | As(III) | DMA | MMA | As(V) | Total arsenic | Conversion rate (%) |
|---|---|---|---|---|---|---|
| 20 | - | - | - | 36.43 | 36.43 | 73 |
| 40 | - | 2.57 | 2.41 | 31.18 | 36.16 | 72 |
| 60 | - | 3.47 | 4.30 | 29.47 | 37.23 | 74 |
| 80 | - | 2.80 | 3.16 | 21.83 | 27.78 | 56 |
| 100 | 2.67 | 5.81 | 3.99 | 18.30 | 30.76 | 62 |

### Embodiment 2 of the Invention

Prepare a mixed solution of Inorganic Mercury, Methylmercury and Ethyl Mercury with each having the same concentration of 50 µg/L. After the sample introduction, conduct the adsorption elution separation on the C18 chromatographic column driven by the mobile phase. The column effluent directly flows through the Ultraviolet pretreatment device of the present invention to undergo the photochemical reaction and conversion. The resulting elemental Mercury is carried into the detector by the carrier gas and detected by the detector, and the signal of each Mercury species is obtained, as shown in Figure 3.

The above described embodiments merely serve to describe the preferred embodiments of the present invention, and do not put any restrictions on the scope of the present invention. Under the premise of the present invention and without departing from the spirits of the present invention design, the various modifications and improvements on the technical solution of the present invention made by the ordinary engineering and technical personnel in this field of art should all fall into the scope of protection stipulated in the Claims of the present invention.

### Industrial Applicability

The Ultraviolet pretreatment device in the present invention is mainly used in the field of element species analysis. Its main components can be mass-produced using the existing production technology; its online digestion efficiency is greatly improved in comparison with the existing technology; and the cost for use is also reduced to some extent. Therefore, it has great market prospects and strong applicability in industry.

## Claims

1. An Ultraviolet pretreatment device comprising a low pressure Mercury lamp (1) and a quartz tube (2), wherein, the said low pressure Mercury lamp (1) comprises a lamp tube (3), electrodes (4) and a power source (5), **characterized in that**: the said quartz tube (2) is located inside the lamp tube (3), the two ends of the quartz tube (2) are fixedly and respectively joined with the tube wall of the lamp tube (3), the inner wall of the said lamp tube (3) and the outer wall of the quartz tube (2) form a sealed gas chamber (6), and the said electrodes (4) are located in the gas chamber (6).

2. The Ultraviolet pretreatment device according to Claim 1, **characterized in that** the two ends of the said quartz tube (2) are respectively connected to the inlet end (7) and the outlet end (8), and the said inlet end (7) and the outlet end (8) are located outside the said lamp tube (3).

3. The Ultraviolet pretreatment device according to Claim 2, **characterized in that** the said quartz tube (2) consists of a plurality of straight-line sections (9) and bending sections (10), the said straight-line sections (9) are, in parallel to each other, distributed within the lamp tube (3) along the length direction of the lamp tube (3), and the straight-line sections (9) are mutually communicated through the bending sections (10).

4. The Ultraviolet pretreatment device according to Claim 3, **characterized in that** the said bending sections (10) are substantially U-shaped, and the outer wall of the bending sections (10) is fixedly joined with the tube wall of the said lamp tube (3).

5. The Ultraviolet pretreatment device according to Claim 4, **characterized in that** the said lamp tube (3) is made from quartz, and the said quartz tube (2) and the lamp tube (3) are fixedly joined by sintering.
